# EUROPEAN PATENT APPLICATION

(11) **EP 4 451 414 A1**
(43) Date of publication of application: **23.10.2024**
(21) Application number: 22906930.7
(22) Date of filing: 29.08.2022
(51) Int. Cl.: H01M 10/42, G01R 31/392, H01M 10/44, H01M 10/48, H02J 7/00

(54) **CHARGING DEVICE, SERVER, AND DIAGNOSTIC SYSTEM**

(30) Priority: 15.12.2021 JP 2021203327
(71) Applicant: Murata Manufacturing Co., Ltd., Nagaokakyo-shi, Kyoto 617-8555 (JP)
(72) Inventor: YANAGIHARA, Asuki, Nagaokakyo-shi, Kyoto 617-8555 (JP); HATTORI, Koji, Nagaokakyo-shi, Kyoto 617-8555 (JP)
(74) Representative: Witte, Weller & Partner Patentanwälte mbB
(86) International application number: PCT/JP2022/032319
(87) International publication number: WO 2023/112394

(57) **Abstract**

A charging device (20) includes a charge-discharge circuit (21), a control device (22), and a communication device (23). The charge-discharge circuit (21) is configured to charge and discharge the secondary battery (10). The control device (22) is configured to control the charge-discharge circuit (21). The communication device (23) is configured to communicate with an outside. The control device (22) is configured to execute processing of acquiring use history information from the secondary battery (10) at a time of starting charging or discharging of the secondary battery (10), processing of causing the secondary battery (10) to temporarily release a charge-discharge prohibited state when the use history information indicates that the secondary battery (10) is in the charge-discharge prohibited state, and processing of acquiring internal state information indicating an internal state of the secondary battery (10) by causing the charge-discharge circuit (21) to charge or discharge the secondary battery (10) in which the charge-discharge prohibited state has been temporarily released. The communication device (23) is configured to execute processing of transmitting internal state information to the outside and processing of receiving deterioration state information, which is generated on the basis of the internal state information and indicates a deterioration state of the secondary battery (10), from the outside. The control device (22) causes the secondary battery (10) to continuously release the charge-discharge prohibited state when the deterioration state information indicates that the secondary battery (10) is in a deterioration state to a degree that it is usable.

## Description

### TECHNICAL FIELD

The present disclosure relates to a charging device for a secondary battery. The present disclosure also relates to a server connected to the charging device via a network. Furthermore, the present disclosure relates to a diagnostic system including the charging device and the server.

### BACKGROUND ART

For example, it is known that a secondary battery such as a lithium ion battery is severely deteriorated when left in a fully charged state without being used for a long period of time. Thus, when the secondary battery is not used for a predetermined period or more, a control circuit (Battery Management System, BMS) in the secondary battery performs control to prohibit charge and discharge. After this control is performed, charging and discharging of the secondary battery cannot be performed, and thus the secondary battery is substantially discarded.

For example, Patent Document 1 discloses a control device that estimates the degree of deterioration of a secondary battery mounted on an electric vehicle. The control device calculates a battery age on the basis of each of a use period of the secondary battery, an accumulated value of a time during which overvoltage of the secondary battery occurs, an accumulated value of a current charged in the secondary battery exceeding a limit value, and an accumulated value of a discharge current of the secondary battery. In Patent Document 1, the battery age is treated as corresponding to the degree of deterioration of the secondary battery, more specifically, an estimated value of a lithium deposition amount. When one or more of calculated battery ages reach an upper limit age, the control device displays a diagnosis request message to urge the user to perform battery diagnosis. When the battery diagnosis is not performed after a predetermined period elapses after the display of the diagnosis request message, the control device restricts or prohibits the use of the secondary battery.

In Patent Document 1, a diagnosis device for performing battery diagnosis is installed, for example, in a repair shop provided in a dealer. In this case, the user of the vehicle on which the secondary battery is mounted needs to go to a dealer to perform battery diagnosis. In the dealer, a vehicle is connected to a dedicated diagnostic device. When the diagnosis device diagnoses that the secondary battery can be continuously used, the control device in the vehicle sets the battery age to an age lower than the upper limit age.

Patent Document 1 describes that a diagnosis device may be provided inside a vehicle. In this case, for example, the diagnosis device in the vehicle executes the battery diagnosis according to the instruction of the user.

### PRIOR ART DOCUMENT

### PATENT DOCUMENT

Patent Document 1: WO 2011/142023 A

### SUMMARY OF THE INVENTION

### Problem to be solved by the invention

In Patent Document 1, in a case where the diagnosis device is provided in a dealer, if a user does not go to the dealer for a long time, battery diagnosis is not performed, and the secondary battery cannot be used as it is. However, with the secondary battery built in the vehicle as in Patent Document 1, it is easy for the user to bring the entire vehicle into the dealer and receive the battery diagnosis. On the other hand, in the case of a secondary battery for general use, when an abnormality occurs in the secondary battery, it is necessary for the user to mail the secondary battery to, for example, a manufacturer to diagnose the state of the secondary battery, which takes labor for the user.

In addition, a cost requirement for a charging device of the secondary battery for general use is usually stricter than that of a vehicle. For example, if the diagnostic device is incorporated in the charging device, the cost required for manufacturing the charging device and the like increases. Thus, it is difficult to provide a diagnosis device capable of performing a relatively advanced battery diagnosis inside the charging device.

An object of the present disclosure is to allow a user to easily determine whether or not a secondary battery is usable without increasing a cost of a charging device.

### Means for solving the problem

A secondary battery charging device according to the present disclosure includes a charge-discharge circuit, a control device, and a communication device. The charge-discharge circuit is configured to charge and discharge the secondary battery. The control device is configured to control the charge-discharge circuit. The communication device is configured to communicate with an outside. The control device is configured to execute processing of acquiring use history information from the secondary battery at a time of starting charging or discharging of the secondary battery, processing of causing the secondary battery to temporarily release a charge-discharge prohibited state when the use history information indicates that the secondary battery is in the charge-discharge prohibited state, and processing of acquiring internal state information indicating an internal state of the secondary battery by causing the charge-discharge circuit to charge or discharge the secondary battery in which the charge-discharge prohibited state has been temporarily released. The communication device is configured to execute processing of transmitting internal state information to the outside and processing of receiving deterioration state information, which is generated on the basis of the internal state information and indicates a deterioration state of the secondary battery, from the outside. The control device causes the secondary battery to continuously release the charge-discharge prohibited state when the deterioration state information indicates that the secondary battery is in a deterioration state to a degree that it is usable.

### Advantageous effect of the invention

According to the present disclosure, a user can easily determine whether or not a secondary battery is usable without increasing cost of a charging device.

### BRIEF EXPLANATION OF DRAWINGS

FIG. 1 is a schematic diagram illustrating a schematic configuration of a diagnostic system according to a first embodiment.
FIG. 2 is a perspective view illustrating a schematic configuration of a secondary battery to be diagnosed by the diagnostic system.
FIG. 3 is a diagram illustrating an example of an equivalent circuit of the secondary battery.
FIG. 4 is a flowchart of deterioration state diagnosis by the diagnostic system.
FIG. 5A is a flowchart of the deterioration state diagnosis by the diagnostic system.
FIG. 5B is a flowchart of the deterioration state diagnosis by the diagnostic system.
FIG. 6 is a diagram illustrating terminal voltage information acquired in the deterioration state diagnosis.
FIG. 7 is a diagram illustrating an open circuit voltage (OCV) curve generated on the basis of terminal voltage information obtained by intermittent discharge.
FIG. 8 is a diagram different from FIG. 6, illustrating terminal voltage information acquired in the deterioration state diagnosis.
FIG. 9 is a diagram illustrating an open circuit voltage (OCV) curve generated on the basis of terminal voltage information obtained by intermittent charging.
FIG. 10 is a diagram illustrating a model waveform of a discharge curve according to a degradation degree of the secondary battery.
FIG. 11 is a diagram illustrating a model waveform of a charging curve according to a degradation degree of the secondary battery.
FIG. 12 is a diagram illustrating a discharge curve of the secondary battery.
FIG. 13 is a diagram illustrating a charging curve of the secondary battery.
FIG. 14 is a model diagram illustrating a temporal transition of an internal state of the secondary battery.
FIG. 15 is a diagram illustrating a factor of degradation of the secondary battery.
FIG. 16 is a diagram illustrating an open circuit voltage curve (during discharge) of a deteriorated secondary battery.
FIG. 17 is a diagram illustrating an open circuit voltage curve (during charging) of the deteriorated secondary battery.
FIG. 18 is a schematic diagram illustrating a schematic configuration of a diagnostic system according to a second embodiment.
FIG. 19 is a schematic diagram illustrating a schematic configuration of a diagnostic system according to a third embodiment.
FIG. 20 is another schematic diagram illustrating a schematic configuration of a diagnostic system according to a third embodiment.

### MODE FOR CARRYING OUT THE INVENTION

A secondary battery charging device according to an embodiment includes a charge-discharge circuit, a control device, and a communication device. The charge-discharge circuit is configured to charge and discharge the secondary battery. The control device is configured to control the charge-discharge circuit. The communication device is configured to communicate with an outside. The control device is configured to execute processing of acquiring use history information from the secondary battery at a time of starting charging or discharging of the secondary battery, processing of causing the secondary battery to temporarily release a charge-discharge prohibited state when the use history information indicates that the secondary battery is in the charge-discharge prohibited state, and processing of acquiring internal state information indicating an internal state of the secondary battery by causing the charge-discharge circuit to charge or discharge the secondary battery in which the charge-discharge prohibited state has been temporarily released. The communication device is configured to execute processing of transmitting internal state information to the outside and processing of receiving deterioration state information, which is generated on the basis of the internal state information and indicates a deterioration state of the secondary battery, from the outside. The control device causes the secondary battery to continuously release the charge-discharge prohibited state when the deterioration state information indicates that the secondary battery is in a deterioration state to a degree that it is usable (first configuration).

The charging device according to the first configuration temporarily releases the charge-discharge prohibited state of the secondary battery if the secondary battery is in the charge-discharge prohibited state, for example, due to the secondary battery being left without being used for a long period of time. The charging device acquires internal state information of the secondary battery using the charge-discharge circuit, and transmits the internal state information to the outside such as a server, for example. The charging device receives deterioration state information of the secondary battery generated on the basis of the internal state information outside the charging device. The charging device can continuously release the charge-discharge prohibited state of the secondary battery, which is a deterioration state that allows use, according to the deterioration state information.

As described above, the charging device according to the first configuration only acquires the internal state information of the secondary battery by using the charge-discharge circuit provided also in a conventional charging device, and generation of the deterioration state information of the secondary battery is performed outside the charging device such as a server, for example. Thus, cost of the charging device does not substantially increase. Further, acquisition and transmission of the internal state information of the secondary battery and reception of the deterioration state information of the secondary battery are automatically performed by the charging device at hand of the user when starting charging or discharging of the secondary battery. The charge-discharge prohibited state of the secondary battery is automatically released according to the deterioration state information of the secondary battery. Thus, the user can easily determine whether or not the secondary battery can be used again without bringing the secondary battery to a manufacturer, a sales store, or the like.

When the deterioration state information indicates that the secondary battery is deteriorated to a degree that it is unusable, the control device may cause the secondary battery to store permanent charge-discharge prohibition information indicating that the secondary battery is permanently in a charge-discharge prohibited state (second configuration).

The charging device according to the second configuration can bring the secondary battery that has deteriorated to an unusable state into a permanent charge-discharge prohibited state. Thus, for example, when the user tries to charge or discharge the secondary battery with the charging device, the charging device can recognize that the secondary battery is in the permanent charge-discharge prohibited state without performing acquisition and transmission of the internal state information as well as reception of the deterioration state information.

The control device may be configured not to execute the processing of acquiring the internal state information when acquiring the permanent charge-discharge prohibition information from the secondary battery at the time of starting charge or discharge of the secondary battery (third configuration).

When recognizing that the secondary battery is in the permanent charge-discharge prohibited state, the charging device according to the third configuration does not acquire the internal state information of the secondary battery. Thus, the internal state information is not transmitted by the charging device, and the deterioration state information of the secondary battery outside the charging device is not generated. Therefore, it is possible to avoid unnecessary diagnosis of the secondary battery already in the permanent charge-discharge prohibited state.

The charging device may be an electronic device on which the secondary battery is mounted and which uses the secondary battery as a power source (fourth configuration).

The charging device according to the fourth configuration is an electronic device itself that uses the secondary battery as a power source. Such an electronic device often includes a wireless LAN module. When the electronic device includes a wireless LAN module, the wireless LAN module can be used as a communication device that transmits and receives internal state information of the secondary battery. Thus, it is not necessary to prepare a charging device including a communication device separately from the electronic device using the secondary battery. This allows the user to easily determine whether or not the secondary battery can be used again without increasing the cost.

The internal state information may include terminal voltage information indicating a terminal voltage of the secondary battery. In this case, the control device can cause the charge-discharge circuit to perform intermittent discharge or intermittent charge of the secondary battery in order to acquire the terminal voltage information. The terminal voltage information can be used to generate open circuit voltage curve information indicating the relationship between a current integrated capacity of the secondary battery and an open circuit voltage of the secondary battery (fifth configuration).

The charging device according to the fifth configuration performs intermittent discharge or intermittent charge to acquire terminal voltage information of the secondary battery. When the intermittent discharge or the intermittent charge is employed, it is not necessary to provide a circuit for variably controlling a charging current, a circuit for variably controlling the discharging load, and the like in the charging device in order to acquire the terminal voltage information. Thus, the cost of the charging device can be further reduced. In addition, in the case of intermittent discharge or intermittent charge, a voltage behavior of the secondary battery during a discharge or charge stop period can be observed. For example, in a charging device or an external server, a deterioration state regarding resistance of the secondary battery can be analyzed in detail using this voltage behavior.

The charging device may further include a display device. The display device is configured to display, for example, the deterioration state information (sixth configuration).

The charging device according to the sixth configuration causes a display device to display deterioration state information of the secondary battery. For example, when deterioration degree information indicating a degree of deterioration of the secondary battery is included in the deterioration state information, the user can be notified of the degree of deterioration of the secondary battery by display by the display device. In addition, by notifying the user of the degree of deterioration of the secondary battery, for example, when the degree of deterioration of the secondary battery is high and the secondary battery becomes unusable, it is possible to prevent the user from misunderstanding that it is a failure of the secondary battery. Therefore, reliability of the user for the secondary battery and the charging device is improved.

When the deterioration state information includes deterioration degree information indicating a degree of deterioration of the secondary battery, and the degree of deterioration indicated by the deterioration degree information is equal to or more than a predetermined degree of deterioration, the control device may cause the secondary battery to store rapid charge-discharge prohibition information indicating a rapid charge-discharge prohibited state (seventh configuration).

The charging device according to the seventh configuration brings the secondary battery into the rapid charge-discharge prohibited state when the secondary battery has a degradation degree equal to or higher than a predetermined degradation degree. In this case, for example, when the user tries to charge or discharge the secondary battery with the charging device, the charging device can be controlled not to perform rapid charge-discharge of the secondary battery, and progress of deterioration of the secondary battery can be delayed.

The server according to the embodiment is connected to a charging device via a network. The charging device is configured to acquire use history information from the secondary battery when starting charging or discharging of the secondary battery. A server is configured to execute processing of receiving internal state information indicating an internal state of the secondary battery acquired by the charging device by temporarily releasing a charge-discharge prohibited state of the secondary battery when the use history information indicates that the secondary battery is in the charge-discharge prohibited state, processing of diagnosing a deterioration state of the secondary battery on the basis of the internal state information and generating deterioration state information indicating a deterioration state of the secondary battery, and processing of transmitting the deterioration state information to an outside (eighth configuration).

The server according to the eighth configuration generates deterioration state information of the secondary battery on the basis of the internal state information of the secondary battery acquired by the charging device. That is, the charging device only acquires internal state information, and advanced or complicated processing of generating deterioration state information is executed by a server outside the charging device. Therefore, the cost of the charging device does not substantially increase. In addition, the processing of acquiring the internal state information to be the basis of the deterioration state information is automatically performed by the charging device at hand of the user when starting charging or discharging of the secondary battery. Thus, without bringing the secondary battery to a manufacturer, a sales store, or the like by the user, the deterioration state information of the secondary battery is generated by the server that has directly or indirectly received the internal state information from the charging device. The charging device can easily determine whether or not the secondary battery can be used again on the basis of the deterioration state information.

The diagnostic system according to the embodiment diagnoses a deterioration state of the secondary battery. The diagnostic system includes the charging device and the server (ninth configuration).

The diagnostic system may further include a user terminal. The user terminal is associated with a secondary battery that can be charged and discharged by the charging device. The user terminal may receive the deterioration state information from the server. The user terminal may display the deterioration state information (tenth configuration).

In the diagnostic system according to the tenth configuration, the deterioration state information of the secondary battery is displayed on the user terminal. In this case, it is not necessary to provide a display device for displaying the deterioration state information and notifying the user in the charging device. Thus, the cost of the charging device can be reduced.

Hereinafter, embodiments of the present disclosure will be described with reference to the drawings. In the drawings, the same or corresponding configurations are denoted by the same reference numerals, and the same description will not be repeated.

### <First Embodiment>

### [Configuration of Diagnostic System]

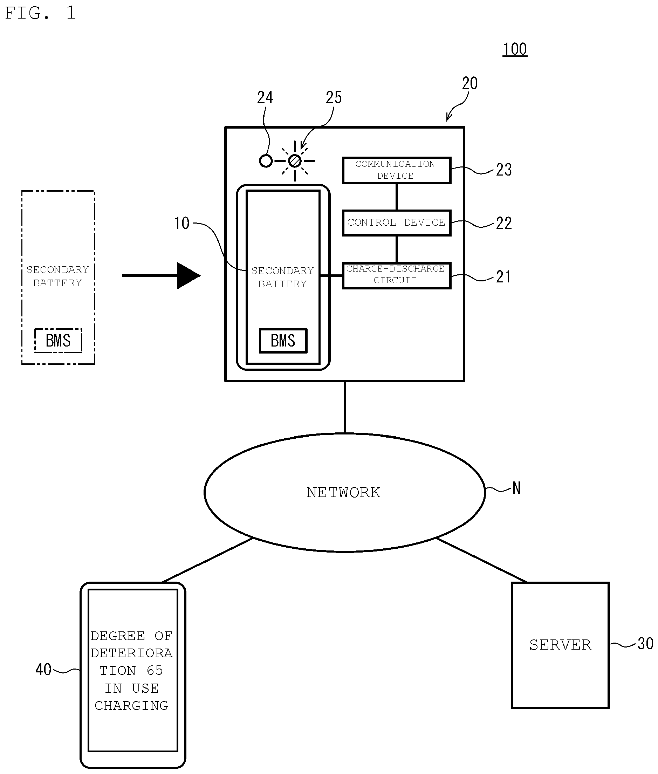

FIG. 1 is a schematic diagram illustrating a schematic configuration of a diagnostic system 100 according to a first embodiment. The diagnostic system 100 is a system for diagnosing a deterioration state of a secondary battery 10. The diagnostic system 100 includes a charging device 20, a server 30, and a user terminal 40.

### (Secondary Battery)

The secondary battery 10 is, for example, a lithium ion secondary battery. The lithium ion secondary battery may be an iron phosphate-based lithium ion battery or a ternary lithium ion battery. The type of the lithium ion secondary battery is not particularly limited. The secondary battery 10 may be a secondary battery other than a lithium ion secondary battery, such as a nickel hydrogen battery, for example. The present embodiment will be described assuming that the secondary battery 10 is a lithium ion secondary battery.

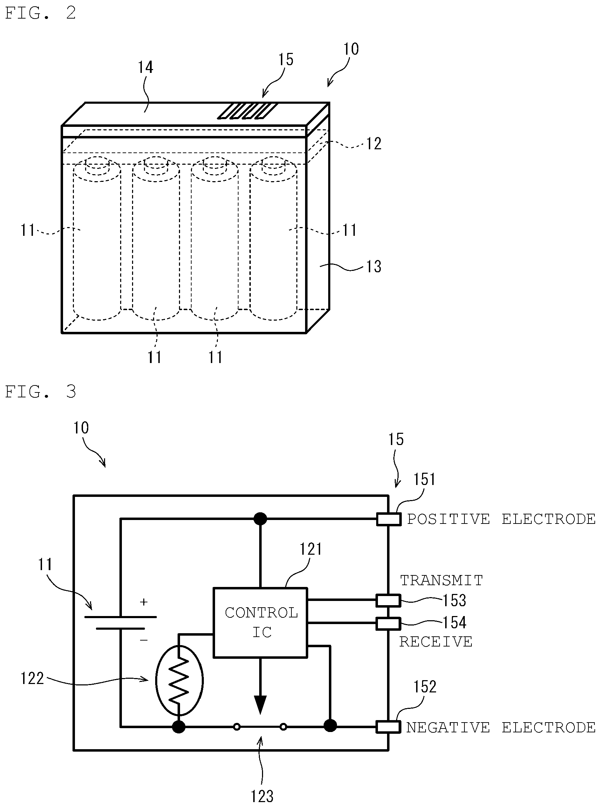

FIG. 2 is a perspective view illustrating a schematic configuration of the secondary battery 10. As illustrated in FIG. 2, the secondary battery 10 includes a plurality of battery cells 11, a control board 12, a case 13, and a top cover 14.

The plurality of battery cells 11 are accommodated in the case 13. The battery cells 11 are connected in series or in parallel, for example, according to a required terminal voltage, capacitance value, or the like. The control board 12 is also accommodated in the case 13. The control board 12 is provided with a control circuit generally called a battery management system (BMS). The top cover 14 closes the opening of the case 13 housing the battery cell 11 and the control board 12. A plurality of terminals 15 is provided on the surface of the top cover 14.

FIG. 3 is a diagram illustrating an example of an equivalent circuit of the secondary battery 10. As illustrated in FIG. 3, the secondary battery 10 is provided with a control IC 121 for controlling charging and discharging of the battery cell 11. The control IC 121 is included in the BMS of the control board 12 (FIG. 2). The control IC 121 monitors the temperature of the battery cell 11 during charging or discharging by the thermistor 122. When detecting abnormal heat generation of the battery cell 11, the control IC 121 turns off, for example, the relay 123 to cut off energization in order to protect the battery cell 11.

The plurality of terminals 15 include a positive electrode terminal 151, a negative electrode terminal 152, and communication terminals 153 and 154. The positive electrode terminal 151 and the negative electrode terminal 152 are terminals for energizing the secondary battery 10. The communication terminals 153 and 154 are terminals for exchanging various types of information with the charging device 20 (FIG. 1). In the example of the present embodiment, the communication terminal 153 is used to transmit information to the charging device 20, and the communication terminal 154 is used to receive information from the charging device 20. That is, in the example of the present embodiment, the transmission communication terminal 153 and the reception communication terminal 154 are separately provided. However, in the secondary battery 10, information can be received and transmitted by a common terminal.

### (Charging Device)

Returning to FIG. 1, the charging device 20 is a device mainly configured to charge the secondary battery 10. The secondary battery 10 is attached to the charging device 20 at a time of charging. The charging device 20 includes a charge-discharge circuit 21, a control device 22, and a communication device 23.

The charge-discharge circuit 21 is configured to charge and discharge the secondary battery 10. The charge-discharge circuit 21 may be a charge-discharge circuit provided in a general charging device. When the secondary battery 10 is attached to the charging device 20, the charge-discharge circuit 21 is electrically connected to the terminals 15 (FIG. 2) of the secondary battery 10.

The control device 22 is configured to control the charge-discharge circuit 21. Further, the control device 22 exchanges information with the secondary battery 10. The control device 22 includes, for example, a central processing unit (CPU) that executes processing (commands) and a memory that stores commands, information, and the like. The control device 22 is, for example, a microcontroller (MCU).

The communication device 23 is configured to communicate with the outside of the charging device 20. The communication device 23 is typically a wireless communication device, and is, for example, a wireless LAN module. The communication device 23 may be, for example, an RFID tag or the like.

The charging device 20 may further include lamps 24 and 25. The lamps 24 and 25 are, for example, LED lamps of different colors. The lamp 24 is turned on when the secondary battery 10 attached to the charging device 20 is being charged. The lamp 25 is turned on when the secondary battery 10 attached to the charging device 20 is not being charged.

### (Server)

The server 30 can be connected to the charging device 20 via the network N. The server 30 may receive information from the charging device 20 and may transmit information to the charging device 20. The server 30 may directly receive information from the charging device 20, or after information transmitted by the charging device 20 passes through the user terminal 40 or another device, the server 30 may receive the information. In addition, the server 30 may directly transmit information to the charging device 20, or can cause the information to reach the charging device 20 via the user terminal 40 or another device.

The server 30 can be connected to the user terminal 40 via the network N. The server 30 can transmit information to the user terminal 40. The server 30 may directly transmit information to the user terminal 40, or can cause the information to reach the user terminal 40 via the charging device 20 or another device.

The server 30 includes, for example, a central processing unit (CPU), a main storage device (main memory), an auxiliary storage device, and the like. The CPU executes processing according to a program loaded from the auxiliary storage device to the main memory. The main storage device is used as a work area that temporarily holds programs, information used by the CPU, calculation results by the CPU, and the like. The auxiliary storage device is, for example, an HDD, a flash memory, a ROM, or the like, and stores programs, various types of information, and the like.

### (User Terminal)

The user terminal 40 is associated with the secondary battery 10. The user terminal 40 is a communication terminal owned by a user of the secondary battery 10. The user terminal 40 may be a portable communication terminal such as a smartphone or a tablet terminal. The user may be, for example, a user who actually uses the secondary battery 10 or a store that sells the secondary battery 10.

### [Diagnosis by Diagnostic System]

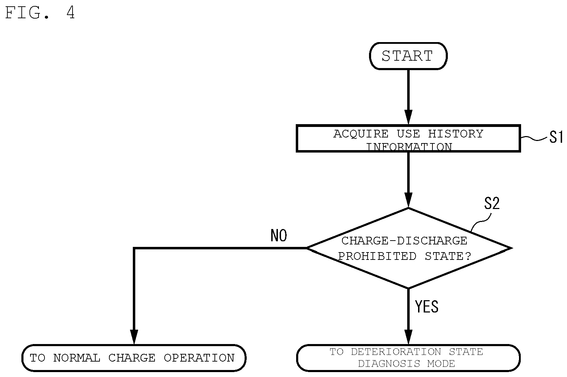

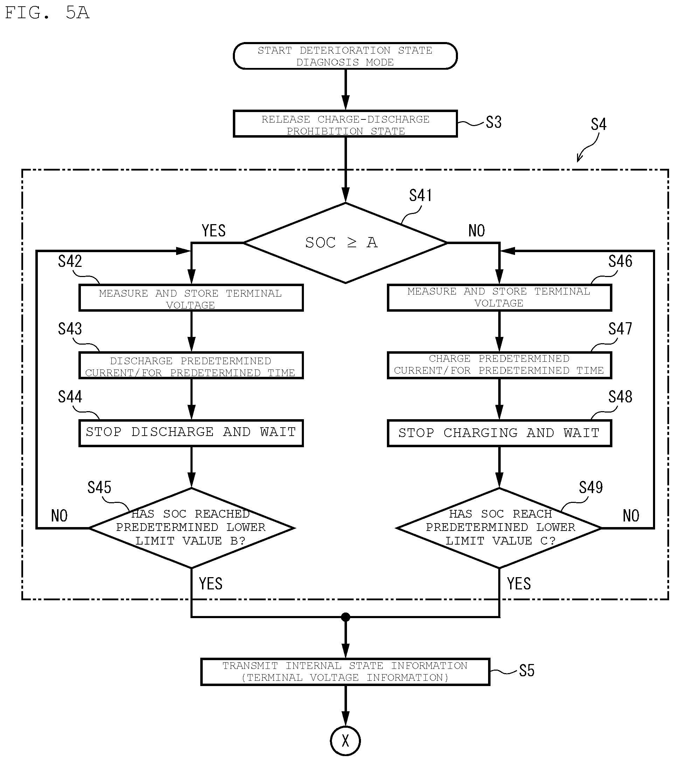

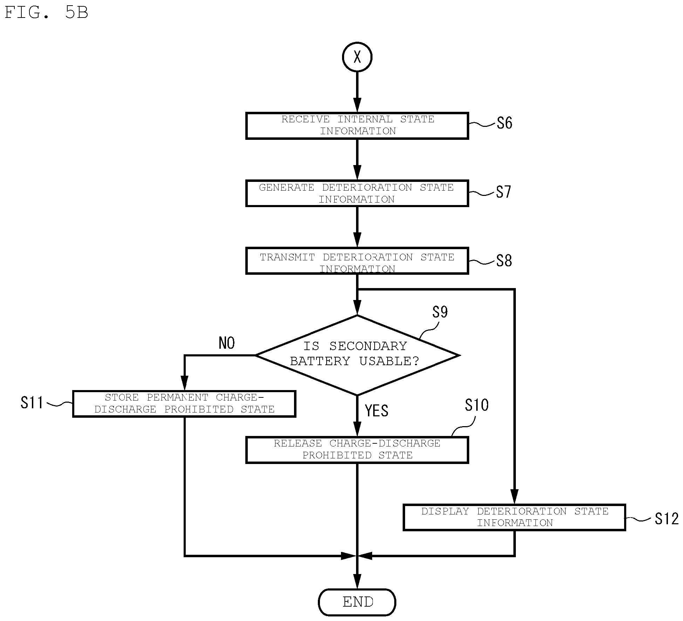

Hereinafter, the diagnosis of the deterioration state performed by the diagnostic system 100 will be described with reference to FIGS. 4, 5A, and 5B. FIGS. 4, 5A, and 5B are flowcharts of deterioration state diagnosis by the diagnostic system 100. The flowcharts of FIGS. 4 and 5A mainly illustrate processing executed by the charging device 20. The flowchart of FIG. 5B includes processing executed by the server 30 or the user terminal 40 in addition to the processing executed by the charging device 20.

Referring to FIG. 4, when the secondary battery 10 is attached to the charging device 20 and the charging device 20 starts charging the secondary battery 10, the control device 22 first acquires use history information from the secondary battery 10 (step S1). More specifically, the control device 22 receives use history information stored in the BMS from the secondary battery 10, and reads the use history information.

When the secondary battery 10 is not charged or discharged for a long period of time, the use history information includes information indicating that the secondary battery 10 is in a charge-discharge prohibited state (primary lock state). The control device 22 of the charging device 20 determines whether or not the secondary battery 10 is in the charge-discharge prohibited state from the use history information (step S2). When the use history information indicates that the secondary battery 10 is in the charge-discharge prohibited state (YES in step S2), the control device 22 starts a deterioration state diagnosis mode. On the other hand, when it is determined from the use history information that the secondary battery 10 is not in the charge-discharge prohibited state (NO in step S2), the control device 22 controls the charge-discharge circuit 21 to start a normal charge operation.

When the normal charging operation is started, the control device 22 turns on the lamp 24. When the deterioration state diagnosis mode is started, the control device 22 turns on the lamp 25. The control device 22 may blink the lamp 25. Thus, it is possible to notify the surroundings that the secondary battery 10 is in the charge-discharge prohibited state (primary lock state) and the deterioration state diagnosis is being performed.

Referring to FIG. 5A, in the deterioration state diagnosis mode, the control device 22 first causes the secondary battery 10 to temporarily release the charge-discharge prohibited state (step S3). For example, the control device 22 transmits information indicating that the deterioration state diagnosis mode is started to the secondary battery 10. Thus, the charge-discharge prohibited state of the secondary battery 10 is temporarily released, and the secondary battery 10 can be charged and discharged.

The control device 22 causes the charge-discharge circuit 21 to charge or discharge the secondary battery 10 in which the charge-discharge prohibited state has been temporarily released, thereby acquiring internal state information indicating an internal state of the secondary battery 10 (step S4). For example, the control device 22 determines whether to charge or discharge the secondary battery 10 according to a state of charge (SOC (%)) of the secondary battery 10. The control device 22 acquires the SOC of the secondary battery 10 and determines whether or not the SOC is equal to or more than a predetermined value A (%) (step S41). The SOC indicates the ratio of the current integrated capacity remaining in the secondary battery 10, where the current integrated capacity of the secondary battery 10 at the time of full charge is 100.

When the SOC is equal to or more than the predetermined value A (YES in step S41), the control device 22 controls the charge-discharge circuit 21 to discharge the secondary battery 10. For example, in order to acquire terminal voltage information indicating a terminal voltage of the secondary battery 10, the control device 22 causes the charge-discharge circuit 21 to perform intermittent discharge of the secondary battery 10. First, the control device 22 measures and stores a voltage (terminal voltage) between the positive electrode terminal 151 and the negative electrode terminal 152 of the secondary battery 10 (step S42) .

Subsequently, the control device 22 causes the secondary battery 10 to discharge a predetermined current for a predetermined time (step S43). For example, the control device 22 causes the secondary battery 10 to discharge at 1 C for 1 minute. Next, the control device 22 stops discharging the secondary battery 10 and waits for a predetermined time (step S44). For example, the control device 22 waits for 30 minutes in a state where the discharge of the secondary battery 10 is stopped.

After the predetermined time has elapsed, the control device 22 acquires the SOC of the secondary battery 10 and determines whether or not the SOC has reached a predetermined lower limit value B (%) (step S45). When the SOC is larger than the lower limit value B (NO in step S45), the control device 22 repeats the processing in steps S42 to S45. When the SOC has reached the lower limit value B (YES in step S45), the control device 22 passes the terminal voltage information including a plurality of stored values of terminal voltages to the communication device 23, and the communication device 23 transmits the terminal voltage information to the server 30 (step S5). The terminal voltage information is included in the internal state information of the secondary battery 10. The terminal voltage information is used to generate open circuit voltage (OCV) curve information of the secondary battery 10. The OCV curve information is information indicating the relationship between the current integrated capacity of the secondary battery 10 and the open circuit voltage of the secondary battery 10. The communication device 23 may directly transmit the internal state information to the server 30, or may indirectly transmit the internal state information via another device.

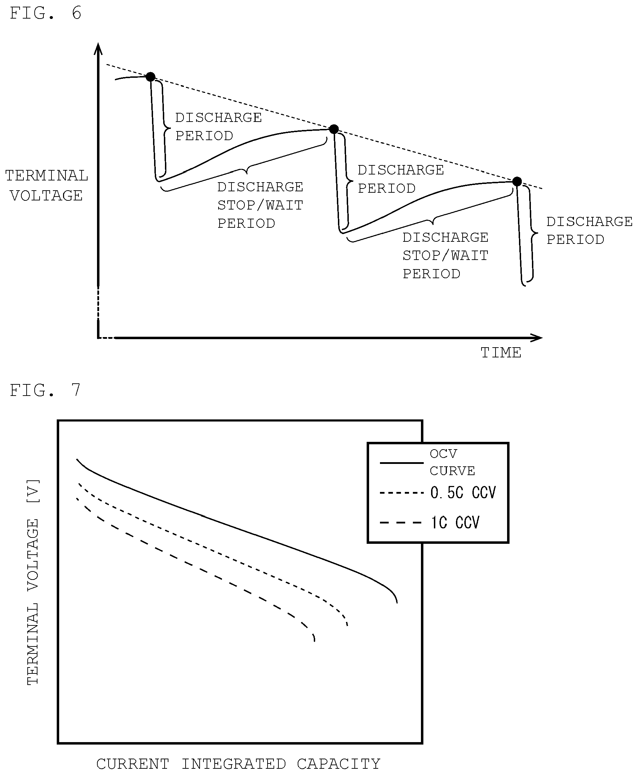

Here, an open circuit voltage curve (OCV curve) generated on the basis of terminal voltage information obtained by intermittent discharge will be described with reference to FIGS. 6 and 7. FIG. 6 is a diagram illustrating terminal voltage information obtained in steps S42 to S45, and FIG. 7 is an example of an OCV curve. The OCV curve is a curve in which a horizontal axis represents the current integrated capacity and a vertical axis represents the open circuit voltage (OCV). The horizontal axis may be the current integrated capacity value (mAh) itself of the secondary battery 10, or may be a ratio of a remaining capacity value to a current integrated capacity value at the time of full charge, that is, SOC (%). The OCV corresponds to the terminal voltage of the secondary battery 10 in a substantially no-load state. When the secondary battery 10 is discharged at 1 C for 1 minute, for example, in step S43, the terminal voltage drops as illustrated in FIG. 6. Thereafter, in step S44, the discharge of the secondary battery 10 is stopped, and the secondary battery 10 is left for 30 minutes, for example, so that fluctuation of electrode potential due to lithium ions having moved in each battery cell 11 during the discharging period in step S43 converges, and the terminal voltage is stabilized. In step S42, the stabilized terminal voltage is measured and stored.

For example, assuming that steps S42 to S45 are repeated N times, the SOC at the time point of k-th (k ≤ N) step S42 slightly decreases as compared with the SOC at the time point of (k - 1)-th step S42 due to the discharge of, for example, 1 minute•1C being performed in (k - 1)-th step S43. The terminal voltage measured in k-th step S42 also drops as compared with the terminal voltage measured in (k - 1)-th step S42 along with a slight decrease of the SOC. An OCV curve as illustrated in FIG. 7 can be generated on the basis of the terminal voltage acquired while repeating steps S42 to S45 and the current integrated capacity during the discharging period.

Returning to FIG. 5A, when the SOC is less than the predetermined value A (NO in step S41), the control device 22 controls the charge-discharge circuit 21 to charge the secondary battery 10. For example, the control device 22 causes the charge-discharge circuit 21 to perform intermittent charging of the secondary battery 10 in order to acquire terminal voltage information of the secondary battery 10. First, the control device 22 measures and stores the terminal voltage of the secondary battery 10 (step S46).

Subsequently, the control device 22 charges the secondary battery 10 with a predetermined current for a predetermined time (step S47). For example, the control device 22 charges the secondary battery 10 at 1 C for 1 minute. Next, the control device 22 stops charging the secondary battery 10 and waits for a predetermined time (step S48). For example, the control device 22 waits for 30 minutes in a state where charging of the secondary battery 10 is stopped.

After the predetermined time has elapsed, the control device 22 acquires the SOC of the secondary battery 10 and determines whether or not the SOC has reached a predetermined upper limit value C (%) (step S49). When the SOC is less than the upper limit value C (NO in step S49), the control device 22 repeats the processing of steps S46 to S49. When the SOC has reached the upper limit value C (YES in step S49), the control device 22 passes the terminal voltage information including the plurality of stored values of terminal voltages to the communication device 23, and the communication device 23 transmits the terminal voltage information to the server 30 (step S5).

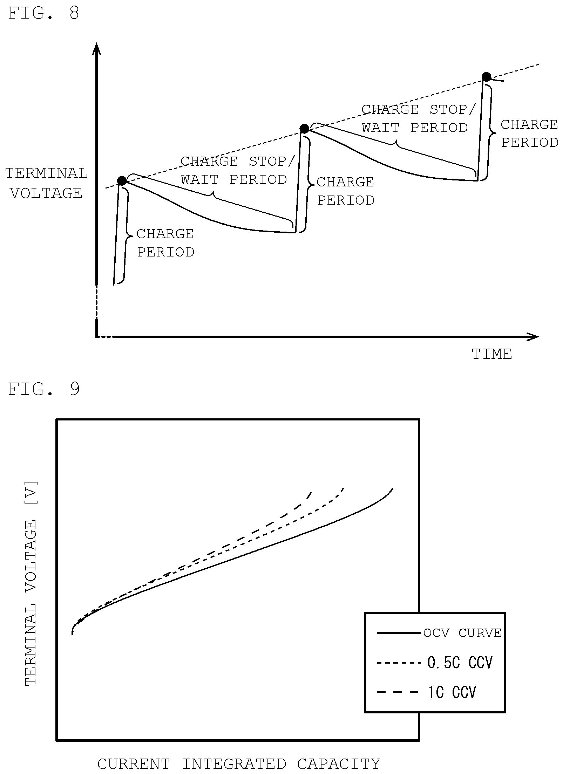

Here, the OCV curve information generated on the basis of the terminal voltage information obtained by the intermittent charging will be described with reference to FIGS. 8 and 9. FIG. 8 is a diagram illustrating terminal voltage information obtained in steps S46 to S49, and FIG. 9 is an example of an OCV curve. When the secondary battery 10 is charged at 1 C for 1 minute, for example, in step S47, the terminal voltage increases as illustrated in FIG. 8. Thereafter, in step S48, the charging of the secondary battery 10 is stopped, and the secondary battery 10 is left for 30 minutes, for example, so that fluctuation of electrode potential due to lithium ions having moved in each battery cell 11 during the charging period in step S47 converges, and the terminal voltage is stabilized. In step S46, the stabilized terminal voltage is measured and stored.

For example, assuming that steps S46 to S49 are repeated N times, the SOC at the time point of k-th (k ≤ N) step S46 slightly increases as compared with the SOC at the time point of (k - 1)-th step S46 due to the charge of, for example, 1 minute•1C being performed in (k - 1)-th step S47. The terminal voltage measured in k-th step S46 also increases as compared with the terminal voltage measured in (k - 1)-th step S46 with the slight increase in the SOC. An OCV curve as illustrated in FIG. 9 can be generated on the basis of the terminal voltage acquired while repeating steps S46 to S49 and the current integrated capacity during the charging period.

Referring to FIG. 5B, the server 30 receives the internal state information of the secondary battery 10 transmitted by the charging device 20 (step S6). The server 30 diagnoses a deterioration state of the secondary battery 10 on the basis of the internal state information, and generates deterioration state information indicating the deterioration state of the secondary battery 10 (step S7).

The internal state information includes the terminal voltage information of the secondary battery 10 collected by the charging device 20, current information of the secondary battery 10 during intermittent discharge or intermittent charge, and the like. In step S7, the server 30 generates OCV curve information indicating the relationship between the current integrated capacity of the secondary battery 10 and the OCV on the basis of the internal state information. However, the OCV curve information may be generated by the charging device 20. In this case, the server 30 receives the OCV curve information from the charging device 20.

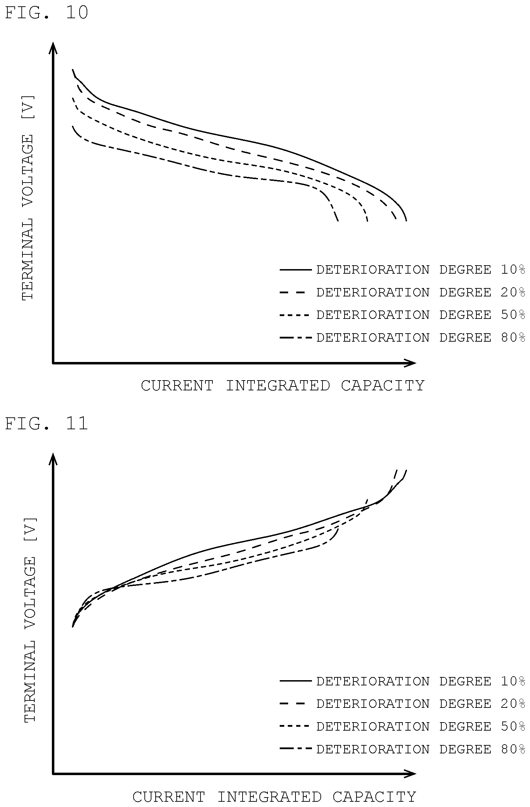

The server 30 determines the deterioration state of the secondary battery 10 on the basis of the OCV curve information. For example, the server 30 stores in advance charge-discharge curve information indicating a plurality of charge-discharge curves (charge curves or discharge curves) according to the degree of deterioration of the secondary battery 10. The server 30 can determine the deterioration state of the secondary battery 10 using the charge-discharge curve information. FIG. 10 is an example of a model waveform of the discharge curve according to the degradation degree. FIG. 11 is an example of a model waveform of the charging curve according to the degradation degree. When the OCV curve information is generated on the basis of the terminal voltage information obtained by the intermittent discharge, for example, the server 30 compares the OCV curve with each model waveform illustrated in FIG. 10, and selects the model waveform closest to the OCV curve. When the OCV curve information is generated on the basis of the terminal voltage information obtained by the intermittent charging, for example, the server 30 compares the OCV curve with each model waveform illustrated in FIG. 11, and selects the model waveform closest to the OCV curve. For example, the server 30 can set the degree of deterioration of the selected model waveform as the degree of deterioration of the secondary battery 10.

The server 30 can also determine the deterioration state of the secondary battery 10 by analyzing the OCV curve information.

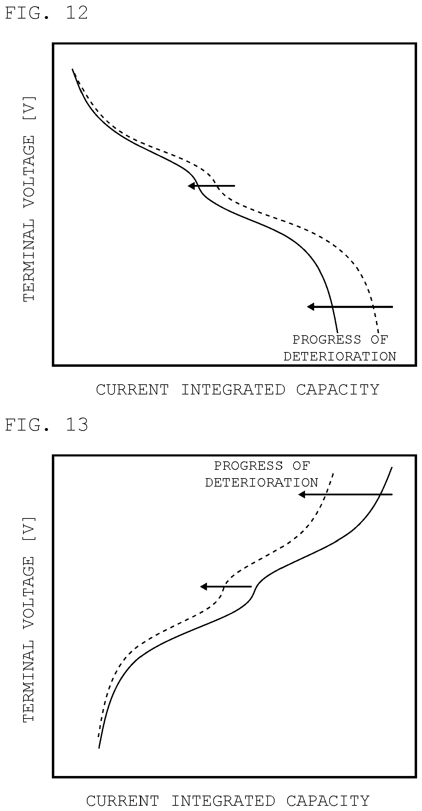

FIG. 12 is a diagram illustrating a discharge curve of the secondary battery 10. FIG. 13 is a diagram illustrating a charging curve of the secondary battery 10. Referring to FIGS. 12 and 13, the shape of the charge-discharge curve of the secondary battery 10 is determined by oxidation-reduction potential of charge-discharge reaction of each of a positive electrode material and a negative electrode material of the battery cell 11, and illustrates a change in voltage characteristic of the material. In the case of the secondary battery 10 in which deterioration is progressing, the charge-discharge curve changes to a curved shape having characteristics of the changed material due to a change in the material of the positive electrode and/or the negative electrode. For example, when a negative electrode formed by a graphite material is deteriorated to reduce a battery capacity, a peak of a characteristic shape change derived from a change in a stage structure of graphite appears in a low SOC region or a high SOC region in a charge-discharge curve. Even if the reaction is not a reaction such as a stage structure change of graphite, the charge-discharge curve illustrates a voltage change according to the characteristics of the oxidation-reduction reaction of the negative electrode. Similarly, the charge-discharge curve illustrates a voltage change according to the characteristics of the oxidation-reduction reaction of the positive electrode.

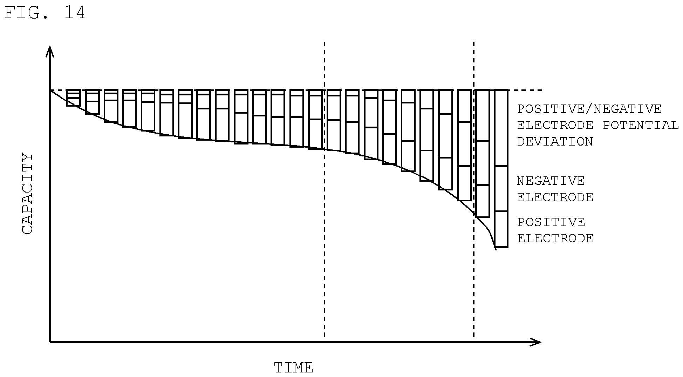

FIG. 14 is a model diagram illustrating a temporal transition of the internal state of the secondary battery 10. In the model exemplified in FIG. 14, the capacity of the battery cell 11 of the secondary battery 10 gradually decreases due to a positive electrode factor at the beginning, but greatly decreases after a negative electrode factor becomes dominant. After a deviation in potential between the positive electrode and the negative electrode becomes a main factor of the capacity decrease, for example, cell swelling due to gas generation occurs, and deterioration of the secondary battery 10 is observed.

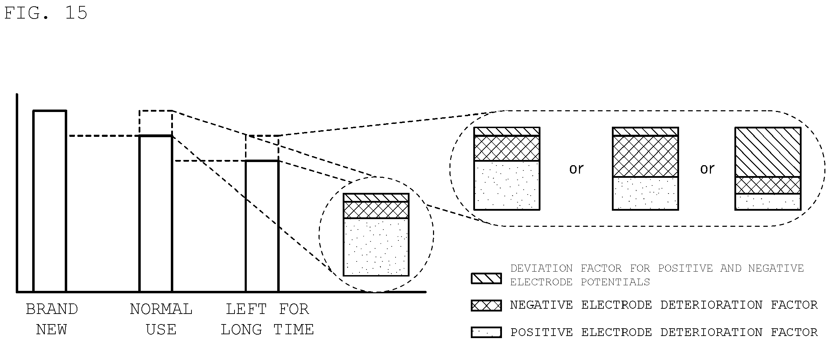

FIG. 15 is a diagram illustrating a factor that the capacity of the battery cell 11 of the secondary battery 10 decreases, that is, the secondary battery 10 deteriorates. As illustrated in FIG. 15, when the secondary battery 10 is used in a normal charge-discharge cycle (normal use), a factor of the capacity decrease is mainly deterioration of the positive electrode material. On the other hand, when the secondary battery 10 is left without being charged or discharged for a long period of time (left for a long period of time), in a factor of capacity reduction, a proportion occupied by deterioration of the negative electrode material increases as compared with the case of normal use, or the deterioration of the negative electrode material or the deviation in potential between the positive electrode and the negative electrode becomes dominant. When the secondary battery 10 is a lithium ion secondary battery, deterioration of the negative electrode material is highly likely to be caused by lithium deposition or the like, and the risk of ignition or the like tends to increase. Thus, for example, the deterioration of the negative electrode material can be a material that determines or estimates a deterioration state of the secondary battery 10.

For example, information for determining or estimating the deterioration state of the secondary battery 10, such as the deterioration of the electrode material, appears on the charge-discharge curve of the secondary battery 10 as described above. The server 30 can quantify information obtained by analyzing a charge-discharge curve as exemplified in FIG. 12 or FIG. 13 as information indicating the deterioration state of the secondary battery 10 and store the quantified information in advance. By analyzing the OCV curve information generated using the internal state information in detail, the server 30 can know how changes in the positive electrode material and the negative electrode material due to deterioration of the secondary battery 10 appear in the shape of the OCV curve. For example, the server 30 can determine the deterioration state of the secondary battery 10 by comparing information of the analysis result of the OCV curve with information stored in advance. The server 30 can also determine the degradation degree of the secondary battery 10 on the basis of the information of the analysis result of the OCV curve and the information stored in advance.

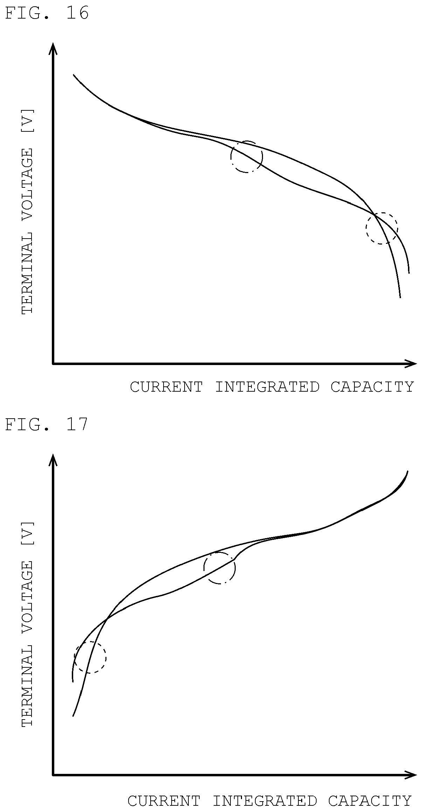

For example, the server 30 can determine the deterioration state of the secondary battery 10 by differentiating the OCV curve and detecting the inclination. For example, when the secondary battery 10 deteriorates as indicated by broken lines in FIGS. 16 and 17, a sudden drop or a sudden rise in the terminal voltage occurs in a region where the remaining capacity of the secondary battery 10 is small. In addition, for example, as indicated by an alternate long and short dash line in FIGS. 16 and 17, when the secondary battery 10 deteriorates, a sudden change in slope may occur in the OCV curve. The server 30 can determine the deterioration state of the secondary battery 10 on the basis of such an inclination of the OCV curve.

Referring to FIG. 5B again, the server 30 transmits the deterioration state information of the secondary battery 10 generated in step S7 to the outside (step S8). For example, the server 30 transmits the deterioration state information of the secondary battery 10 to the charging device 20 and the user terminal 40. The deterioration state information includes deterioration degree information indicating a degree of deterioration of the secondary battery 10.

In the charging device 20, the communication device 23 receives the deterioration state information. The control device 22 determines whether or not to cancel the charge-discharge prohibited state of the secondary battery 10 on the basis of the deterioration state information received by the communication device 23. The control device 22 determines whether or not the deterioration state information indicates that the secondary battery 10 is in a deterioration state to a degree that it is usable (step S9).

When the secondary battery 10 is in a deterioration state to the degree that it is usable (YES in step S9), the control device 22 causes the secondary battery 10 to continuously release the charge-discharge prohibited state (primary lock state) (step S10). For example, when the degree of deterioration of the secondary battery 10 is equal to or less than a predetermined degree of deterioration D1, the control device 22 causes the secondary battery 10 to cancel the charge-discharge prohibited state. Alternatively, when the deterioration state information generated by the server 30 includes information indicating that the secondary battery 10 is usable, the control device 22 causes the secondary battery 10 to cancel the charge-discharge prohibited state according to the information.

The control device 22 transmits a command to cancel the charge-discharge prohibited state to the secondary battery 10. In the secondary battery 10, the BMS rewrites the use history information to cancel the charge-discharge prohibited state. Thus, the secondary battery 10 becomes usable. The control device 22 can start charging the secondary battery 10 (normal charging operation) by controlling the charge-discharge circuit 21. In this case, the control device 22 turns off the lamp 25 indicating that the deterioration state diagnosis is being performed and turns on the lamp 24 indicating that the charging is being performed. Thus, the surrounding people are notified that the charge-discharge prohibited state of the secondary battery 10 has been continuously released.

When the secondary battery 10 is not in a deterioration state to the degree that it is usable (NO in step S9), the control device 22 does not cause the secondary battery 10 to release the charge-discharge prohibited state. When the deterioration state information indicates that the secondary battery 10 is deteriorated to an unusable degree (NO in step S9), the control device 22 causes the secondary battery 10 to store, for example, the permanent charge-discharge prohibition information indicating that the secondary battery is permanently in a charge-discharge prohibited state (step S11). For example, the control device 22 may transmit a command to set the secondary battery 10 to the permanent charge-discharge prohibited state, and cause the BMS to rewrite the use history information to set the secondary battery 10 to the permanent charge-discharge prohibited state (permanent lock state). For example, the control device 22 notifies the surroundings that the secondary battery 10 is unusable by switching the blinking lamp 25 to the always-on state.

When receiving the deterioration state information of the secondary battery 10, the user terminal 40 displays the deterioration state information on its own display (step S12). The deterioration state information displayed by the user terminal 40 includes deterioration degree information of the secondary battery 10. In addition to the deterioration degree information, availability information of the secondary battery 10 and the like may be displayed on the user terminal 40. The information displayed on the user terminal 40 is not particularly limited. For example, when the secondary battery 10 is in the permanent charge-discharge prohibited state, the user terminal 40 can also display information indicating the fact.

### [Effects]

In the present embodiment, the charging device 20 only acquires the internal state information of the secondary battery 10 by diverting the charge-discharge circuit 21 provided also in the conventional charging device, and generation of the deterioration state information of the secondary battery 10 is performed by the server 30. That is, a relatively advanced process of diagnosing the deterioration state of the secondary battery 10 is imposed on the server 30, and the charging device 20 performs only a relatively simple process. Thus, the cost of the charging device 20 does not substantially increase.

In the present embodiment, the diagnosis of the deterioration state of the secondary battery 10 (deterioration state diagnosis mode) is automatically started only by the user attaching the secondary battery 10 that has been unused for a long period to the charging device 20. When the secondary battery 10 is in a deterioration state to the degree that it is usable, the charging device 20 automatically releases the charge-discharge prohibited state of the secondary battery 10. Thus, the user can easily determine whether or not the secondary battery 10 can be used again without bringing the secondary battery to a manufacturer, a sales store, or the like.

In the present embodiment, when the secondary battery 10 is in a deterioration state to the degree that it is usable, the charge-discharge prohibited state of the secondary battery 10 is released by the charging device 20, and the secondary battery 10 becomes usable. Thus, it is possible to prevent disposal of the secondary battery 10 that is in the charge-discharge prohibited state due to being left for a long period of time or the like although it can be actually used. Therefore, the amount of waste of the secondary battery 10 can be reduced, and the environmental load can be reduced.

In the present embodiment, when the secondary battery 10 is determined to be unusable as a result of diagnosis, the charging device 20 preferably changes the secondary battery 10 to the permanent charge-discharge prohibited state (permanent lock state). Thus, for example, when the user tries to charge or discharge the secondary battery 10 with the charging device 20, the charging device 20 can recognize that the secondary battery 10 is in the permanent charge-discharge prohibited state without measuring the internal state of the secondary battery 10 and diagnosing the deterioration state. Therefore, unnecessary diagnosis of the deterioration state of the secondary battery 10 can be avoided.

For example, when reading the use history information of the BMS in step S2, the charging device 20 can determine whether or not information indicating that the secondary battery 10 is in the permanent charge-discharge prohibited state is included in the use history information. When the secondary battery 10 is in the permanent charge-discharge prohibited state, the charging device 20 does not shift to the deterioration state diagnosis mode or to the normal charging operation, and can end the processing. For example, the charging device 20 may notify the user that the secondary battery 10 is in the permanent charge-discharge prohibited state by turning on the lamp 25 at all times. The charging device 20 can also transmit information indicating the permanent charge-discharge prohibited state to the user terminal 40 by the communication device 23. In this case, the user terminal 40 can display, for example, a message indicating that the secondary battery 10 is in the permanent charge-discharge prohibited state on the display.

In the present embodiment, the charging device 20 performs intermittent discharge or intermittent charge in order to acquire terminal voltage information of the secondary battery 10. In this case, it is not necessary to provide a circuit for variably controlling a charging current, a circuit for variably controlling a discharging load, and the like in the charging device 20 in order to acquire the terminal voltage information. Therefore, the cost of the charging device 20 can be further reduced. Further, in the case of intermittent discharge or intermittent charge, the voltage behavior of the secondary battery 10 during the discharge or charge stop period can be observed. If voltage behavior information of the secondary battery 10 is included in the internal state information, for example, in the server 30, the deterioration state regarding resistance of the secondary battery 10 can be analyzed in detail using the voltage behavior information.

In the present embodiment, the charging device 20 measures and stores the terminal voltage information until the SOC reaches the predetermined lower limit value B or until the SOC reaches the predetermined upper limit value C, and transmits all the terminal voltage information necessary for generating the OCV curve to the server 30 at a time. However, the charging device 20 can transmit the terminal voltage information necessary for generating the OCV curve in a plurality of times. The charging device 20 may transmit the measured terminal voltage information in real time.

In the present embodiment, when the degree of deterioration of the secondary battery 10 is equal to or greater than a predetermined degree of deterioration D2 (D2 < D1), the control device 22 can cause the secondary battery 10 to store rapid charge-discharge prohibition information indicating a rapid charge-discharge prohibited state. For example, in step S10, the control device 22 can transmit a command to the secondary battery 10, rewrite the use history information so as to cancel the charge-discharge prohibited state, and write the rapid charge-discharge prohibited state in the use history information. In this case, for example, when the user tries to charge or discharge the secondary battery 10 with the charging device 20, the control device 22 can control the charge-discharge circuit 21 so as not to perform rapid charge-discharge of the secondary battery 10. Therefore, the progress of deterioration of the secondary battery 10 can be delayed.

When reading the use history information and recognizing that the secondary battery 10 is in the rapid charge-discharge prohibited state, the charging device 20 may transmit information indicating the fact to the user terminal 40. In this case, the user terminal 40 can display, for example, a message indicating that the secondary battery 10 is in the rapid charge-discharge prohibited state on the display.

In the present embodiment, the deterioration degree information of the secondary battery 10 is displayed on the display of the user terminal 40. In this case, the user can recognize the degree of deterioration of the secondary battery 10. In addition, by notifying the user of the degree of deterioration of the secondary battery 10, for example, when the degree of deterioration of the secondary battery 10 is high and the secondary battery 10 becomes unusable, it is possible to prevent the user from misunderstanding that it is a failure of the secondary battery 10. Therefore, reliability of the user for the secondary battery 10 and the charging device 20 can be improved.

When the deterioration state information including the deterioration degree information of the secondary battery 10 is displayed on the user terminal 40, the charging device 20 does not need to be provided with a display device for displaying the information. Thus, the cost of the charging device 20 can be reduced.

### <Second Embodiment>

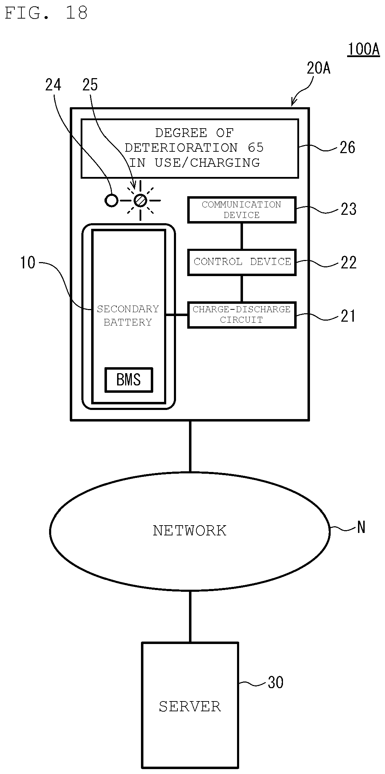

FIG. 18 is a schematic diagram illustrating a schematic configuration of a diagnostic system 100A according to the second embodiment. The present embodiment is different from the first embodiment in that a charging device 20A includes a display device 26.

The diagnostic system 100A executes processing similar to that of the diagnostic system 100 according to the first embodiment. However, in the diagnostic system 100A, when the charging device 20A receives deterioration state information of the secondary battery 10 from the server 30, the charging device 20A displays the deterioration state information on its own display device 26. The deterioration state information displayed on the display device 26 includes, for example, deterioration degree information of the secondary battery 10. In addition to the deterioration degree information, availability information of the secondary battery 10 and the like may be displayed on the display device 26. The information displayed on the display device 26 is not particularly limited. For example, when the secondary battery 10 is in a permanent charge-discharge prohibited state or in a rapid charge prohibited state, the display device 26 can also display information indicating the fact.

The deterioration state information of the secondary battery 10 may be displayed on the user terminal 40 (FIG. 1) in addition to the charging device 20A.

With the configuration of the diagnostic system 100A according to the present embodiment, it is possible to achieve effects equivalent to those of the diagnostic system 100 according to the first embodiment.

### <Third Embodiment>

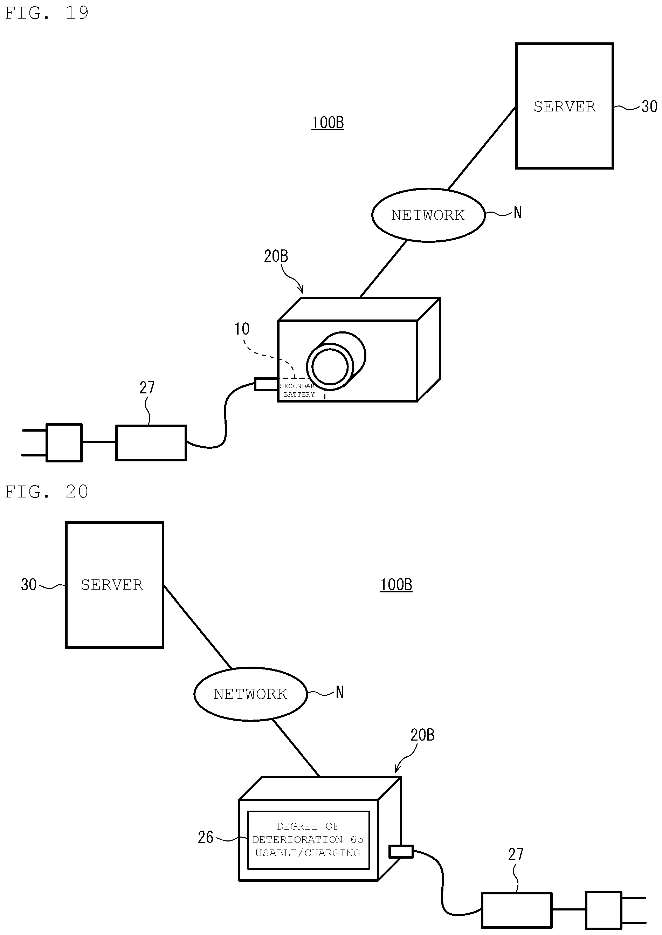

FIGS. 19 and 20 are schematic diagrams illustrating a schematic configuration of a diagnostic system 100B according to a third embodiment. The present embodiment is different from the above embodiment in that the charging device 20B is an electronic device.

The charging device 20B is an electronic device on which the secondary battery 10 is mounted and which uses the secondary battery 10 as a power source. In the present embodiment, an example in which the charging device 20B is a digital camera will be described. However, the charging device 20B is not necessarily a digital camera.

Although not illustrated in FIGS. 19 and 20, the charging device 20B, which is a digital camera, incorporates a circuit capable of charging the secondary battery 10 similarly to the charge-discharge circuit 21 described in the first embodiment. For example, an AC adapter cable 27 is connected to the charging device 20B, and the secondary battery 10 is charged inside the charging device 20B.

Although not illustrated in FIGS. 19 and 20, the charging device 20B incorporates, for example, a charge-discharge control IC and a wireless LAN module. The charge-discharge control IC and the wireless LAN module can be used as the control device 22 and the communication device 23 described in the first embodiment, respectively.

As illustrated in FIG. 20, the charging device 20B is a digital camera, and thus includes a liquid crystal monitor. This display can be used as the display device 26 described in the second embodiment. As in the second embodiment, when the charging device 20B receives the deterioration state information of the secondary battery 10 from the server 30, the deterioration state information is displayed on the display device 26. The deterioration state information of the secondary battery 10 may be displayed on the user terminal 40 (FIG. 1) in addition to the charging device 20B.

The diagnostic system 100B according to the present embodiment executes the same processing as the diagnostic system 100 or 100A according to the above embodiment, for example, when the secondary battery 10 is charged or discharged in order for the user to use the charging device 20B (digital camera) that has been left for a long time. At a time of starting charging or discharging of the secondary battery 10, the charging device 20B acquires use history information from the secondary battery 10 and performs a deterioration state diagnosis mode or a normal charging or discharging operation. With the configuration of the diagnostic system 100B, it is possible to achieve an effect equivalent to that of the diagnostic system 100 or 100A according to the above embodiment. Furthermore, in a case where the charging device 20B is an electronic device as in the present embodiment, the charge-discharge control IC and the wireless LAN module originally incorporated in the electronic device can be used as the control device 22 that acquires the internal state information of the secondary battery 10 and the communication device 23 that transmits the internal state information. When the electronic device includes a monitor, the monitor can be used as the display device 26 that displays the deterioration state of the secondary battery 10. In this case, it is not necessary to prepare a charging device including a communication device and a display device separately from the charging device 20B as an electronic device using the secondary battery 10. Therefore, an increase in cost can be suppressed.

Although the embodiments according to the present disclosure have been described above, the present disclosure is not limited to the above-described embodiments, and various modifications can be made without departing from the gist thereof.

In the above embodiment, the deterioration state of the secondary battery 10 is diagnosed on the basis of the OCV curve generated using the terminal voltage information. However, the OCV curve is not necessarily used to diagnose the deterioration state. For example, the charging devices 20, 20A, and 20B can acquire terminal voltage information by performing charging or discharging in a state where a load is applied to the secondary battery 10. However, it is preferable that charging or discharging of the secondary battery 10 is performed at a rate as low as possible. The server 30 can use the charge-discharge curve generated on the basis of the terminal voltage information by the charging device 20, 20A, or 20B or the server 30 for diagnosis of the deterioration state. The diagnosis of the deterioration state using such a charge-discharge curve can be performed similarly to the diagnosis of the deterioration state using the OCV curve.

The internal state information of the secondary battery 10 acquired by the charging devices 20, 20A, and 20B may not include the terminal voltage information. For example, the charging devices 20, 20A, and 20B can acquire internal resistance information indicating internal resistance of the secondary battery 10 as the internal state information. For example, the charging devices 20, 20A, and 20B apply alternating current (for example, 0.1 Hz to 5.0 kHz) having different frequencies to the secondary battery 10, measure an alternating current voltage and an alternating current of the secondary battery 10 for each frequency, and calculate impedance for each frequency on the basis of the alternating current voltage and the alternating current. The charging devices 20, 20A, and 20B can transmit impedance information of the secondary battery 10 to the server 30 as internal resistance information. However, the calculation of the impedance may be executed by the server 30.

The server 30 can calculate the life of the secondary battery 10 on the basis of the impedance information of the secondary battery 10. The server 30 can include calculated life information in the deterioration state information of the secondary battery 10.

### DESCRIPTION OF REFERENCE SYMBOLS

100, 100A, 100B: Diagnostic system
10: Secondary battery
20, 20A, 20B: Charging device
21: Charge-discharge circuit
22: Control device
23: Communication device
26: Display device
30: Server
40: User terminal
N: Network

## Claims

1. A charging device for a secondary battery, comprising:
a charge-discharge circuit configured to charge and discharge the secondary battery;
a control device configured to control the charge-discharge circuit; and
a communications device configured to communicate with an outside, wherein
the control device is configured to execute
processing of acquiring use history information from the secondary battery at a time of starting charging or discharging of the secondary battery,
processing of causing the secondary battery to temporarily release a charge-discharge prohibited state when the use history information indicates that the secondary battery is in the charge-discharge prohibited state, and
processing of acquiring internal state information indicating an internal state of the secondary battery by causing the charge-discharge circuit to charge or discharge the secondary battery in which the charge-discharge prohibited state has been temporarily released, and
the communication device is configured to execute
processing of transmitting the internal state information to an outside, and
processing of receiving deterioration state information, which is generated on a basis of the internal state information and indicates a deterioration state of the secondary battery, from the outside, and
the control device causes the secondary battery to continuously release the charge-discharge prohibited state when the deterioration state information indicates that the secondary battery is in a deterioration state to a degree that it is usable.

2. The charging device according to claim 1, wherein when the deterioration state information indicates that the secondary battery is deteriorated to a degree that it is unusable, the control device causes the secondary battery to store permanent charge-discharge prohibition information indicating that the secondary battery is permanently in a charge-discharge prohibited state.

3. The charging device according to claim 2, wherein the control device is configured not to execute the processing of acquiring the internal state information when acquiring the permanent charge-discharge prohibition information from the secondary battery at a time of starting charging or discharging of the secondary battery.

4. The charging device according to any one of claims 1 to 3, wherein the charging device is an electronic device on which the secondary battery is mounted and which uses the secondary battery as a power source.

5. The charging device according to any one of claims 1 to 4, wherein
the internal state information indicates a terminal voltage of the secondary battery, and includes terminal voltage information used to generate open circuit voltage curve information indicating a relationship between a current integrated capacity of the secondary battery and an open circuit voltage of the secondary battery, and
the control device causes the charge-discharge circuit to perform intermittent discharge or intermittent charge of the secondary battery in order to acquire the terminal voltage information.

6. The charging device according to any one of claims 1 to 5, further comprising
a display device configured to display the deterioration state information.

7. The charging device according to any one of claims 1 to 6, wherein when the deterioration state information includes deterioration degree information indicating a degree of deterioration of the secondary battery, and the degree of deterioration indicated by the deterioration degree information is equal to or more than a predetermined degree of deterioration, the control device causes the secondary battery to store rapid charge-discharge prohibition information indicating a rapid charge-discharge prohibited state.

8. A server connected via a network to a charging device configured to acquire use history information from a secondary battery at a time of starting charging or discharging of the secondary battery, the server being configured to execute:
processing of receiving internal state information indicating an internal state of the secondary battery acquired by the charging device by temporarily releasing a charge-discharge prohibited state of the secondary battery when the use history information indicates that the secondary battery is in the charge-discharge prohibited state;
processing of diagnosing a deterioration state of the secondary battery on a basis of the internal state information and generating deterioration state information indicating a deterioration state of the secondary battery; and
processing of transmitting the deterioration state information to an outside.

9. A diagnostic system that diagnoses a deterioration state of a secondary battery, the diagnostic system comprising:
the charging device according to any one of claims 1 to 7; and
the server according to claim 8.

10. The diagnostic system according to claim 9, further comprising
a user terminal that is associated with a secondary battery that is capable of being charged and discharged by the charging device, receives the deterioration state information from the server, and displays the deterioration state information.
